# EUROPEAN PATENT APPLICATION

(11) **EP 0 633 614 A1**
(43) Date of publication of application: **11.01.1995**
(21) Application number: 93202032.4
(22) Date of filing: 08.07.1993
(51) Int. Cl.: H01L 33/00

(54) **Polymer based tunable light emitting diode**

(71) Applicant: Rijksuniversiteit te Groningen, NL-9712 CP Groningen (NL)
(72) Inventor: Gill, Richard, 9747 AG Groningen (NL); Hadziioannou, Georges, 9322 EL Peize (NL); Wildeman, Jurgen, 9747 AG Groningen (NL); Malliaris, George, 9747 AG Groningen (NL)
(74) Representative: Smulders, Theodorus A.H.J., Ir.

(57) **Abstract**

The invention concerns a light emitting diode (LED) emitting light having a wavelength from 400 to 850 nm comprising a layer of an electroluminescing material, electrodes and optionally carrier material and/or reflecting material, said electroluminescing material comprising at least one polymer comprising a polymer backbone, wherein the π-conjugation of the backbone is distorted by interaction of substituents on the backbone.

## Description

The present invention is directed to a polymer based tunable light emitting diode (LED).

Commercial LED devices are made of inorganic semiconductors e.g. GaAs, GaP, etc. which cover almost the whole spectral region. It would be advantageous to have an organic material with electroluminescence in the blue region, as organic materials are usually more easy to process.

The production of an effective blue LED using organic materials has however not been accomplished yet, which is one of the reasons for the search for alternative materials. Although low molecular weight organic materials are known to give luminescence even with high efficiencies, only recently the use in electroluminescent devices was reported. A disadvantage of the use of low molecular weight organic materials in devices is their tendency to recrystallize.

The use of organic materials in the production of LED has certain advantages, especially from the viewpoint of processability.

One of the important advantages of the polymer LED is its ease of fabrication. The active polymer or prepolymer can be cast from solution on a substrate which makes it possible to fabricate large-area devices. Conjugated polymers can cover the whole spectral region by chemical tuning of the wavelength of the emission by choice of the polymer and control of the conjugation length of the polymer. Another promising feature is the additional use of a conducting polymer as the hole-injecting electrode resulting in a fully flexible LED.

Suitable candidates for applications in stable optoelectronic devices are conjugated polymers. Polymers can be processed relatively easily and especially large area structures are feasible. The first encouraging results were reported by Burroughes ET AL (Nature, 347, 477 (1992)), Braun ET AL. (Appl. Phys. Lett. 58, 1982(1992)) and Grem ET AL. (Adv. Mater.4, 36 (1992)), using poly(p-phenylene vinylene)s and poly(p-phenylene) as the electroluminescent layer.

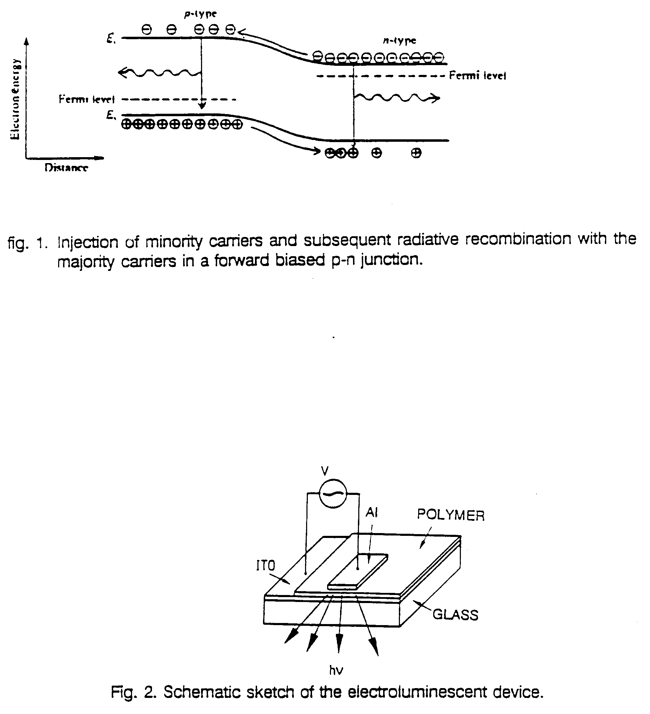

The basic element giving rise to injection luminescence is that of a p-n junction diode operated under forward bias as is illustrated in fig. 1.

The electrons recombine with holes and give rise to emitted photons. In the ideal case each injected electron takes part in the radiative recombination but in practice this is not the case. The quantum efficiency of a device made of an inorganic semiconductor emitting in the visible region lies in the range 0.05 to 4%. The wavelength of the emitted photon is determined by the energy band gap (ideal case). For example GaAs has a band gap of 1.43 eV. In order to obtain visible radiation, the energy gap has to be larger than 2 eV. For a blue LED a band gap of 3.4 eV is required. Inorganic semiconductors like SiC with these large band gaps tend to have high resistivities next to fabrication problems because of high melting temperatures and structural stability.

A large number of organic materials has extremely high fluorescent quantum efficiencies in the whole visible spectral region. The major problem with organic crystals is the high voltage needed to inject charges. The drive voltage to obtain a significant light output is in the order of 100 V or above. The use of thin solid films lowers the drive voltage but the efficiency still is extremely low.

Recently, it has been reported that LED's can be made of organic thin films by using a multilayer structure. An emitting layer is combined with or sandwiched between a hole and an electron injecting layer.

A LED emitting bright blue light was achieved, thus with a luminance of 700 cd/m2 at a DC drive voltage of 10 V. Unfortunately the stability of the cell is not good yet. Probably recrystallization of the organic layers due to produced heat causes degradation of the cell.

Burroughes et AL. (loc.cit.) and Braun et AL. (loc. cit.) clearly demonstrated that LEDs can be made with conjugated polymers. Their main advantage over nonpolymeric (in)organic semiconductors is the possibility of processing to form large area structures. The structure of such a LED is shown in figure 2.

A substrate, usually glass is covered with the transparent electrode, e.g. indium/tin oxide (ITO) functioning as the hole injecting cathode. The emitting layer or a prepolymer is spincoated on top of this layer and covered with a top electrode e.g. Al or Ca, the electron injecting anode. The choice of the electrodes is important. Metals with a low work function give higher efficiencies. Disadvantage of these electrodes is the oxidative instability. By choosing a polymeric substrate, polyethyleneterephthalate (PET), covered with transparent processable polyaniline as the hole injecting electrode, G. Gustafsson et AL., Nature, 357 477 (1992) even fabricated a fully flexible LED. The electroluminescent polymer used by the above mentioned scientists is poly(p-phenylene vinylene) or a soluble alkoxy derivative thereof.

The electroluminescence spectra of these materials are very similar to their photoluminescence spectra. The photoluminescence of PPV's is assigned to radiative combination of the singlet polaron exciton (also called neutral bipolaron) formed by intrachain excitation.

The electroluminescence is assigned to the same excited state and is generated by recombinations of holes and electrons injected from opposite sides of the structure. The charge carriers are probably polarons. Because the quantum yield of photoluminescence of PPV is about 8%, the non-radiative processes limit the efficiency of LEDs. This is caused by migration of the excited states to defect sites which act as non-radiative recombination centres. When the conjugation length of a polymer is increased this migration will go faster and efficiency will lower. This was clearly demonstrated by Burn et AL. by synthesizing a copolymer that can be converted by heat treatment from a conjugated/non-conjugated polymer into a fully conjugated polymer. The quantum yields for electroluminescence of the conjugated/nonconjugated polymers were strongly enhanced. The non-conjugate part acts as a trap for the excitons, preventing the migration to quenching sites.

As has been described in European patent application No. 92204100.9, titled 'Light emitting diode', the contents of which is incorporated herein by way of reference, multi blockcopolymers containing thiophene blocks of 2 to 15 units have been found to possess suitably tunable electroluminescent properties, which make them especially suitable for use in polymeric LED's.

The invention is aimed at providing a light emitting diode (LED) emitting light with a wavelength of from 400 to 850 nm comprising an electroluminescing material, electrodes and optionally carrier material and/or reflecting material, said LED being tunable, stable and easy to manufacture at low cost.

According to the teaching of the cited European patent application the π-conjugation of the thiophene blocks is restricted by intermediate blocks having no π-conjugation.

One of the objects of the present invention is to provide an LED containing as active component at least one polymer from the class of polymers based on thiophene derivatives.

The invention is based upon the use of one or more polymers in a polymeric LED, which polymer comprises a polymer backbone having a distorted π-conjugation due to interaction of substituents on the backbone.

The invention is thus defined as a light emitting diode (LED), emitting light with wavelength of from 400 to 850 nm comprising a layer of an electroluminescing material, electrodes and optionally carrier material and/or reflecting material, said electroluminescing material comprising at least one polymer comprising a polymer backbone, wherein the π-conjugation of the backbone is distorted by interaction of substituents on the backbone.

The construction of the devices according to the invention can be done in accordance with the description given in the introduction, using the specific active materials as defined in accordance with the present invention. It is to be noted that the active polymeric component may consist of a combination (blend) of two or more active polymers, or a blend of one or more active polymers with one or more other polymer, inactive polymers. In the device additional layers having electron or hole transport properties may be present.

According to a preferred embodiment of the invention the steric repulsion between substituents and the polymer backbone, intrachain backbone-sidechain steric repulsion, forces the backbone out of coplanarity and π-conjugation.

Preferably the polymer backbone is of such a composition that without the said interaction, the backbone would be fully π-conjugated. However, it is also possible to include a limited number of non π-conjugated blocks in the polymer.

The wavelength of the emitted light depends on the length of the π-conjugation, that is on the number of monomeric units in the polymer backbone that have a joint π-conjugation. Generally the length varies between 1 and 10 units. With shorter length, the emitted light becomes more blue, whereas longer blocks lead to more reddish emitted light.

According to a preferred embodiment the monomeric units in the polymer are thiophene based. An essential aspect is that there is a substituent present on a number of thiophene units, leading to the required steric repulsion forces. It has been found that substituents on the 3 and/or 4 position of the thiophene ring result in a steric repulsion sufficient to force the rings out of coplanarity, resulting in a distortion of the π-conjugation.

Accordingly the thiophene polymers to be used in accordance with the invention must be substituted on the thiophene ring in order to distort the π-conjugation. Preferably the substituents are C₁ to C₂₀ alkyl, aryl, alkaryl, aralkyl, alkoxy or aralkoxy. It is also possible to use silane or polysilane based substituents.

Depending on the required properties the number of thiophene units can be selected, as well as the type and number of substituents. It is essential that at least one of the thiophene rings is substituted as otherwise the processability is insufficient. Preferably at least two of the rings in each block are substituted with alkyl, aryl, alkaryl, aralkyl, alkoxy, aralkoxy and the like, each substituent containing one to 20 carbon atoms. Also suitable are silane and polysilane substituents. According to a preferred embodiment, the polymer is represented by the formula 5 of the formula sheet, wherein m, n, o, and p are integers having a value of 0 to 4, the sum thereof being at least 1, and q is an integer having a value of at least 1, with the proviso that in the formula at least one thiophene unit has at least one substituent. This means in practice that at least one of m and n are not 0.

It is to be noted that when using the polymers of the present invention in opto-electronics and more in particular in electro-luminescent devices, the length of the blocks has a profound influence on the wave length of the light. Also important is the choice of the various substituents.

The invention is also directed to novel thiophene polymers suitable for use in an LED, said polymers being selected from the group of polymers according to formula 5, wherein
a. n, o and p are 0, m and q ≠ 0, and R₁ and R₂ are not H;
b. m, n and o are 1, p = 0, q ≠ 0, R₂ and R₃ are not H and R₁, R₄-R₆ are H; or
c. m, n, o and p are 1, q ≠ 0, R₂ and R₃ are not H and R₁, R₄-R₈ are H.

As the thiophene based polymers show thermochromism and solvatochromism, they are eminently suitable for use in devices that make use of those properties, such as thermosensors, wherein in the colour of the emitted light varies with the temperature. The solvatochromism can be put to use by using polymeric substrates containing small amounts of enclosed solvent, resulting in another colour than would be expected on the basis of the length of the π-conjugation.

As has been indicated earlier, the polymer preferably does not contain blocks that do not possess π-conjugation. In case there are nevertheless some blocks present, suitable materials for said blocks are based on silicium, germanium or on carbon-carbon oligomers. Of the latter group, especially the styrenic materials, like oligostyrene, and oligomers of styrene derivatives are suitable.

The polymers to be used in the present invention can be produced using methods known in the art, such as oxidative coupling with iron(III)chloride of thiophene units, catalytic polymerization of thiophene units, for example nickel(II)chloride.dppp catalysed Grignard reactions, or palladium catalysed coupling reactions. A number of process routes have been schematically indicated in the attached formula sheet. Some other methods have been described in Maior, Synthesis and Characterization of Two Regiochemically Defined Poly (dialkylbithiophenes): A comparative Study, Macromolecules, **1990**, 23, 1269-1279.

The present invention is elucidated on the basis of the following examples and reaction schemes, without being limited thereto.

### EXAMPLES

### Synthesis of poly 3,4-dioctylthiophene

3,4-Dioctylthiophene (0.99 g, 3.22 mmol) in 15 ml of dry CHCl₃ was added to six equivalents of dry FeC1₃ suspended in 50 ml of dry CHCl₃. The reaction mixture was stirred overnight and the crude reaction product was precipitated twice in excess cold methanol. The precipitate, a dark blue solid, was vacuum dried yielding 0.90 g (91%) of polymer.

### Synthesis of polv(3,3'-2,2'- dioctylbithiophene)

Two equivalents of n-BuLi were added to 2.64 g (6.77 mmol) of 3,3'dioctyl-2,2'-bithiophene dissolved in 50 ml diethylether. By adding two equivalents of MgBr₂.Et₂0 in Et₂0 the dilithiumsalt was converted to the diGrignard. The resulting mixture was added to an equimolar amount of dibromo-3,3'dioctyl-2,2'-bithiophene and 1% NiCl₂.dppp in 50 ml of Et₂0 and stirring was continued overnight. The crude reaction product was precipitated twice in excess cold methanol. The precipitate, a yellow solid, was vacuum dried yielding precipitate, a yellow solid, was vacuum dried yielding 4.2 g (79%) of polymer.

### Synthesis of poly(3,3'dioctyl-tetrathiophene)

Two equivalents of n-BuLi were added to 2.5 g (6.41 mmol) of 3,3'dioctyl-2,2'-bithiophene dissolved in 50 ml of THF. By adding two equivalents of MgBr₂.Et₂0 in Et₂0 the dilithiumsalt was converted to the diGrignard. The resulting mixture was added to an equimolar amount of dibromobithienyl and 1% NiCl₂.dppp in 150 ml of THF and stirring was continued overnight. The crude reaction product was precipitated twice in excess cold methanol. The precipitate, a red solid, was vacuum dried yielding 2.7 g (77%) of polymer.

### Synthesis of poly(3-octylthiophene)

Lithiumdiisopropylamine, 0.10 mol was added to 27.5 g (0.10 mol) of 2-bromo-3-octylthiophene dissolved in 200 ml of THF at -40 °C. By adding one equivalent of MgBr₂.Et₂0 in Et₂0 the lithiumsalt was converted to the Grignard. The resulting mixture was added in two hours to two equivalents of 2-bromo-3-octylthiophene and 1% NiCl₂.dppp in 100 ml of THF and stirring was continued overnight. The crude reaction product was precipitated in methanol and washed successively with methanol, water, methanol and cold chloroform (50 ml). The precipitate, a red solid, was vacuum dried to give 7.0 g (48 % yield based on the amount of converted bromo-3-octylthiophene) of polymer.

### Preparation of the films

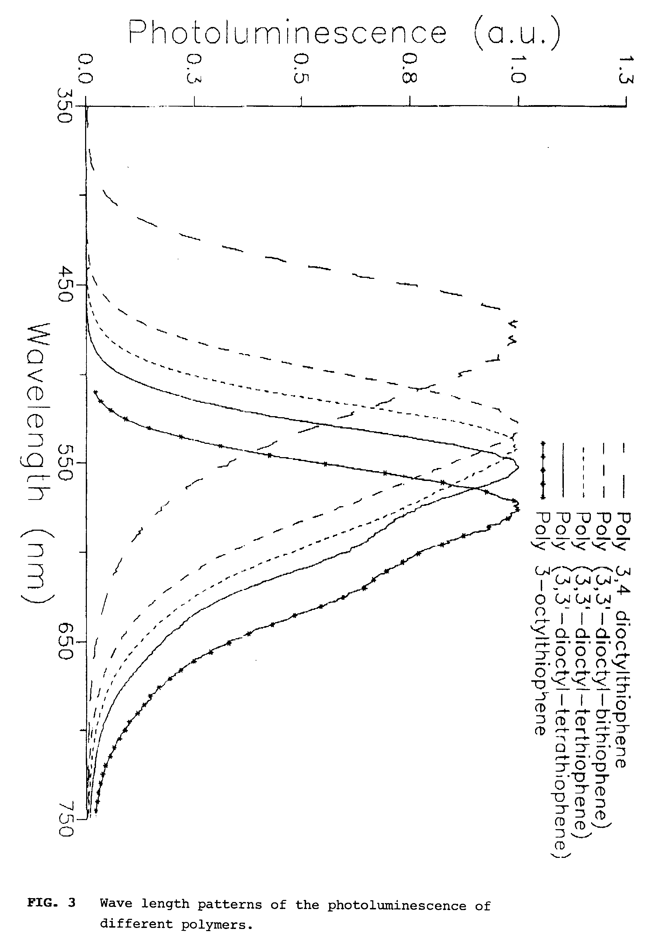

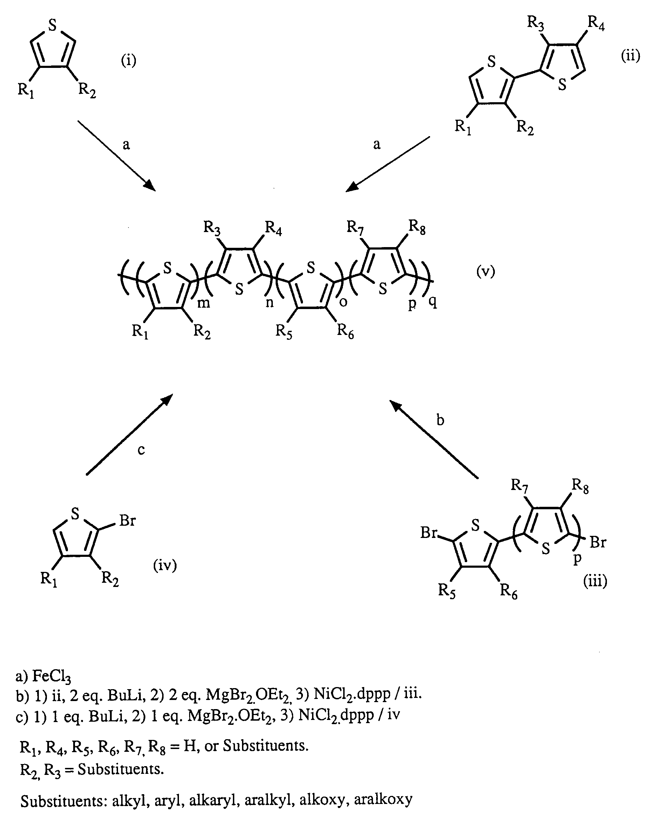

Thin films of the polymers were prepared by spincoating 5-15% solutions of the various polymers in an organic solvent on a glass slide covered with indium tin oxide. Various metal electrodes (Ca, Al, In, Sn, Mg and alloys of these metals) were evaporated at low pressure (10-6 torr). The films were assembled into an LED. The wave length patterns of the photoluminescence of the different polymers have been given in Fig. 3.

## Claims

1. Light emitting diode (LED) emitting light having a wavelength from 400 to 850 nm comprising a layer of an electroluminescing material, electrodes and optionally carrier material and/or reflecting material, said electroluminescing material comprising at least one polymer comprising a polymer backbone, wherein the π-conjugation of the backbone is distorted by interaction of substituents on the backbone.

2. LED according to claim 1, wherein intrachain backbone-sidechain steric repulsion in the polymer forces the backbone out of coplanarity and π-conjugation.

3. LED according to claim 1 or 2, wherein the polymer backbone is of such a composition that without the said interaction, the backbone would be fully π-conjugated.

4. LED acording to claims 1-3, wherein the polymer comprises blocks of π-conjugated units, the blocklength being between 1 and 10.

5. LED according to claims 1-4, wherein the polymer backbone is based upon thiophene units.

6. LED according to claim 1-5, wherein the polymer is a homopolymer or copolymer of substituted thiophene.

7. LED according to claim 6, wherein the polymer comprises at least one thiophene unit of the formula 1, wherein at least one of R₁ and R₂ is a C₁ to C₂₀ alkyl, aryl, alkaryl, aralkyl, alkoxy or aralkoxy substituent, or a silane or polysilane based substituent.

8. LED according to claim 7, wherein the polymer is represented by the formula 5 of the formula sheet, wherein m, n, o, and p are integers having a value of 0 to 4, the sum thereof being at least 1, and q is an integer having a value of at least 1, with the proviso that in the polymer at least one thiophene unit having at least one substituent, for example as defined in claim 7, is present.

9. LED according to any one of the claims 1-8, wherein electron and/or hole transport layers are present.

10. LED according to any one of the claims 1-9, wherein the active material has been blended with one or more other polymers.

11. LED according to any one of the claims 1-10, wherein the material of at least one of the electrodes has been selected from the group of Ca, Al, In, Sn, Mg and alloys of these metals.

12. Thiophene polymer suitable for use in an LED according to any one of the claims 1-11, said polymer being selected from the group of polymers according to formula 5, wherein
a. n, o and p are 0, m and q ≠ 0, and R₁ and R₂ are not H;
b. m, n and o are 1, p = 0, q ≠ 0, R₂ and R₃ are not H and R₁, R₄-R₆ are H; or
c. m, n, o and p are 1, q ≠ 0, R₂ and R₃ are not H and R₁, R₄-R₈ are H.

13. Process for the preparation of a thiophene polymer according to claim 12, said process comprising oxidative coupling with iron(III)chloride of thiophene units, catalytic polymerization of thiophene units, for example nickel (II) chloride.dppp catalysed Grignard reactions, or palladium catalysed coupling reactions.

14. Temperature sensor comprising an LED according to any one of the claims 1-11.
